# EUROPEAN PATENT SPECIFICATION

(11) **EP 2 404 185 B1**
(45) Date of publication and mention of the grant of the patent: **03.10.2018**
(21) Application number: 09781860.3
(22) Date of filing: 14.08.2009
(51) Int. Cl.: G01R 31/36, H02J 7/00

(54) **METHOD AND ARRANGEMENT FOR DETERMINING ENERGY SOURCE UNIT STATUS**
VERFAHREN UND ANORDNUNG ZUR BESTIMMUNG DES ENERGIEQUELLENEINHEITSSTATUS
PROCÉDÉ ET AGENCEMENT PERMETTANT DE DÉTERMINER L'ÉTAT D'UNE UNITÉ DE SOURCE D'ÉNERGIE

(30) Priority: 02.03.2009 US 396357
(43) Date of publication of application: 11.01.2012
(73) Proprietor: Sony Mobile Communications Inc., Shinagawa-ku Tokyo 140-0002 (JP)
(72) Inventor: SVENSSON, Jan-Olof, SE-277 35 Kivik (SE); WOLF, Mats, SE-247 35 Södra Sandby (SE); HANSSON, Kent, SE-230 40 Bara Bara (SE)
(74) Representative: Aera A/S
(86) International application number: PCT/EP2009/060558
(87) International publication number: WO 2010/099836

(56) References cited:
- EP-A- 1 873 541
- EP-A- 2 006 734
- US-A1- 2007 063 676
- US-A1- 2007 188 144
- US-A1- 2007 229 035
- US-A1- 2008 133 956
- US-B1- 6 545 448
- US-B1- 6 879 259
- US-B2- 7 123 155

## Description

### TECHNICAL FIELD

The invention relates to a method and an arrangement, in particular, for determining status of an energy source unit assembled within an electronic device.

### BACKGROUND

Today, features in communication terminals, such as cellular phones or the like, are increasing in numbers, adding value to services used by a user of the communication terminal. The user is, for example, informed graphically about the remaining capacity of a rechargeable battery of the communication terminal in the graphic user interface of the communication terminal. The remaining capacity may be illustrated as a battery filled to a level depending on the remaining capacity of the battery and/or as a percentage of the fully loaded battery. However, the full load capacity of the battery as well as the time to drain a fully charged battery changes over time due to reduced performance/status of the battery and the like. Finally, the battery needs to be replaced due to the low performance of the battery and the user/a service centre replaces the battery with a new battery. In some designs of mobile terminals, batteries may be embedded in the mobile terminal wherein only a service centre should exchange batteries. A problem today when a customer returns or complains about an electronic device comprising a battery is that the battery is replaced without actually showing poor performance, leading to a waste of resources and time.

### SUMMARY

An object of some embodiments herein is to provide a way to improve error detection of an electronic device.

This object has been achieved by a method according to claim 1.

In some embodiments, the method further comprises to store the status of the energy source unit.

The measured value may comprise a measured time, voltage and/or the like.

The above object has also been achieved by an arrangement according to claim 5.

The control unit may, in some embodiments, further be arranged to store the status in a memory of the arrangement.

The measured value may in some embodiments comprise a measured time, voltage, current, and/or the like.

The application may be arranged to be initiated manually from a menu displayed in the electronic device.

The arrangement may in some embodiments comprise the energy source unit.

The above object has also been achieved by an electronic device comprising such an arrangement and by a battery pack comprising such an arrangement.

As a consequence, a simple reference for an energy source unit performance, such as a battery performance, may be used to explain (to the customer, service personnel) whether battery performance is acceptable or not without having to dismount the battery from a connected state.

### BRIEF DESCRIPTION OF THE DRAWINGS

Embodiments will now be described in more detail in relation to the enclosed drawings, in which:
Figure 1 shows a schematic overview of a mobile terminal,
Figure 2 shows a schematic overview of a graphical menu of a mobile terminal,
Figure 3 shows a schematic overview of a graphical menu of a mobile terminal,
Figure 4 shows a schematic diagram of a discharge of a battery in a first state,
Figure 5 shows a schematic diagram of a discharge of a battery in a second state,
Figure 6 shows a schematic overview of a method in an electronic device, and
Figure 7 shows a schematic overview of an electronic device.

### DETAILED DESCRIPTION

Various embodiments of the present invention will now be described more fully hereinafter with reference to the accompanying drawings. However, this invention should not be construed as limited to the embodiments set forth herein. Rather, these embodiments are provided so that this disclosure will be thorough and complete, and will convey the scope of the invention to those skilled in the art.

It will be understood that, as used herein, the term "comprising" or "comprises" is openended, and includes one or more stated elements, steps and/or functions without precluding one or more unstated elements, steps and/or functions. As used herein, the singular forms "a", "an" and "the" are intended to include the plural forms as well, unless the context clearly indicates otherwise. The term "and/or" and "/" includes any and all combinations of one or more of the associated listed items. In the drawings, the size and relative sizes of regions may be exaggerated for clarity. Like numbers refer to like elements throughout.

Some embodiments may be embodied in hardware and/or in software (including firmware, resident software, micro-code, etc.). Consequently, as used herein, the term "signal" may take the form of a continuous waveform and/or discrete value(s), such as digital value(s) in a memory or register. Furthermore, various embodiments may take the form of a computer program product on a computer-usable or computer-readable storage medium having computer-usable or computer-readable program code embodied in the medium for use by or in connection with an instruction execution system. Accordingly, as used herein, the terms "control unit" may take the form of digital circuitry, such as computer-readable program code executed by an instruction processing device(s) (e.g., general purpose microprocessor and/or digital signal processor), and/or analogue circuitry.

Embodiments are described below with reference to block diagrams and operational flow charts. It is to be understood that the functions/acts noted in the blocks may occur out of the order noted in the operational illustrations. For example, two blocks shown in succession may in fact be executed substantially concurrently or the blocks may sometimes be executed in the reverse order, depending upon the functionality/acts involved. Although some of the diagrams include arrows on communication paths to show a primary direction of communication, it is to be understood that communication may occur in the opposite direction to the depicted arrows.

As used herein, an electronic device may comprise a "mobile terminal" or terminal. A mobile terminal or terminal includes, but is not limited to, any portable electronic device. The mobile terminal may be configured to transmit/receive communication signals via a long range wireless interface such as, for example, a cellular interface, via a short range wireless interface such as, for example, a Near Field Communication (NFC) interface, a Bluetooth wireless interface, a wireless local area network (WLAN) interface such as IEEE 801.11a-g, and/or via another radio frequency (RF) interface. Example terminals include, but are not limited to, cellular phones, PDAs, and mobile computers that are configured to communicate with other terminals via a cellular communication network, a Bluetooth communication network, WLAN communication network, and/or another RF communication network. Other terminals may be media players, cameras and or the like.

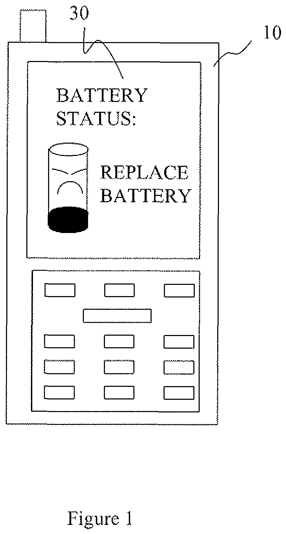

In figure 1, a schematic overview of an electronic device being a wireless mobile terminal 10 containing an energy source needing supervision, such as a battery, is shown.

The terminal 10 comprises a function that is executed to determine status of the connected battery being the energy source of the terminal. The function may be initiated periodically, manually, automatically and/or the like, for example, during times when the usage of the terminal is low such as during night time and/or the like. The function may be executed by an application wherein test values (time, voltage) from a new/nominal battery are compared to values of the present battery.

As a consequence, a simple reference for battery performance may be used to explain (to the customer, service staff) whether battery performance is acceptable or not. In the illustrated embodiment, the function generates an illustration of a sad battery stating that the battery need to be replaced in a graphical user interface 30 of the terminal. Hence, a battery, such as an embedded battery, does not need to be removed to be tested to determine the performance of the battery.

By the use of carefully selected well known current consumption applications (already included in the phone/device), or measure real performance of battery using existing applications the state-of-health of the battery to the customer may be determined. This will lead to that customer service gets an easy reference level against customers as well as means to explain/persuade the customer not to worry for battery performance when it comes to embedded/replaceable batteries. As an example, a manufacturer will replace poor performing batteries free of charge if they show <80% using built in monitoring within 2 years. Of course this would preferably also include the possibility to monitor different usage cases, (number of charge cycles, total use-time, etc.).

Different implementations of the battery performance detection may be:
End user: User is uncertain if battery is ok or has lost performance. He enters the status menu and can directly read the status. The status shall be shown in the Phone information menu and clearly indicate if battery is within expected lifespan.
Repair centre : Repair Technician receives a Phone where the owner complain about low battery performance, he opens the service menu and can read the status and amount of charge cycles performed since last reset. It can then be judged if the performance is considered worse or in-line with expected, according to use case.

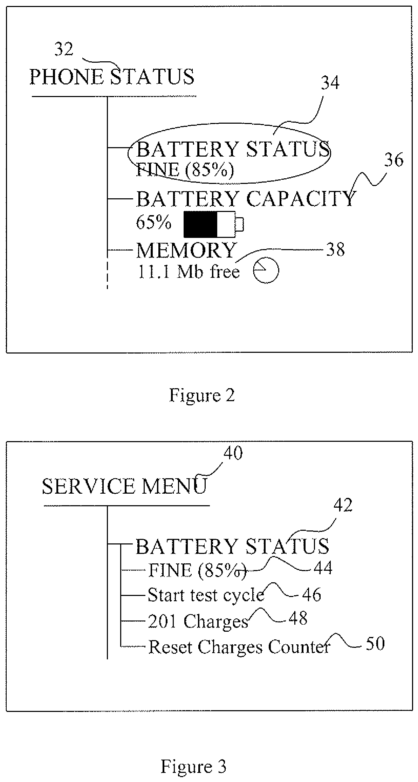

In figure 2, a schematic overview of a graphical menu of a mobile terminal is shown.

The graphical menu of the mobile terminal comprises different features and functions. A user may, for example, start an application in a menu but may also retrieve information about the performance of the mobile phone. In the illustrated example a menu view shows a phone status 32 comprising battery status 34, battery capacity 36, memory 38 indicating free memory capacity and/or more.

The battery status 34 is indicating the performance of the battery. The performance is based on a comparison between a performance of a first state of the battery and a performance of a second (present) state of the battery. The performance of the first state may indicate performance of the battery just after manufacturing, just installed, first time used, a nominal performance of a battery, original state, and/or the like. The performance of the second state may indicate the performance at the moment, at the latest execution of a "determine performance" - application and/or the like.

In figure 3, an exemplary embodiment of a graphical menu of a mobile terminal is shown.

In the illustrated example, a service menu is shown. The service menu comprises a menu that may be retrieved by pressing keys in a preset sequence of a key pad of the mobile terminal. In some embodiments, the service menu is intended for the service staff during service of the mobile terminal and that is why a certain sequence of keys has to be depressed to display the service menu.

From the service menu a battery status 42 may be read; the battery status may comprise a first indication 44 of the performance stating whether the battery is fine or not, a first selectable item 46 enabling a user to manually initiate a self test cycle, a second indication 48 indicating number of times the battery has been recharged, a second selectable item 50 enabling a user to reset a counter counting the number of times a battery has been charged, for example, to be executed after replacing the battery; and/or more selectable items, functions and/or the like.

The following items is illustrated in the example under item "Battery status" 42 in the Service Menu 40:
Battery status (same as in Phone info menu) 44,
Initiate a test of the battery status 46,
Number of Full cycle charges since reset 48,
Reset of Full Charge cycle counter 50.

It should be understood that other items may also be considered and displayed, for example, temperature limits exceeded, measurements of humidity of the mobile terminal being in an operational state, registering that the mobile terminal has been subjected to high impact and/or the like. Different arrangements may be used to register these events.

There are different implementations where the battery status may be used. For example;

Repair Technician receives a mobile terminal where the owner complains about low battery performance of, for example, a mobile terminal with an embedded battery. The repair technician opens the service menu and can start a test sequence where the actual battery capacity is measured by performing a charge/discharge cycle and the result is compared with a nominal specification for the particular battery type; and/or
a user is uncertain if a battery is ok or has lost capacity and enters the status menu and can directly read the status. The status may be shown in the Phone information menu and clearly indicate if battery is within expected lifespan; and/or the like.

It may be possible to read the life time status of the battery package from both the Phone Information menu and from a selection in the Service menu. It may also be a service that is displayed after an application has been executed to determine the life time status of the battery package.

It should be noted that an embedded battery causes the user to send the device to a repair centre every time the user suspects the battery is out of capacity, that is, has a low performance or the like. If no diagnostics exist it will cause a battery replacement. The feature of displaying the battery status of the embedded battery (as well as a battery exchangeable by the user) will prevent a large amount of uncertainty and will reduce the amount of "no trouble found" runs in repair.

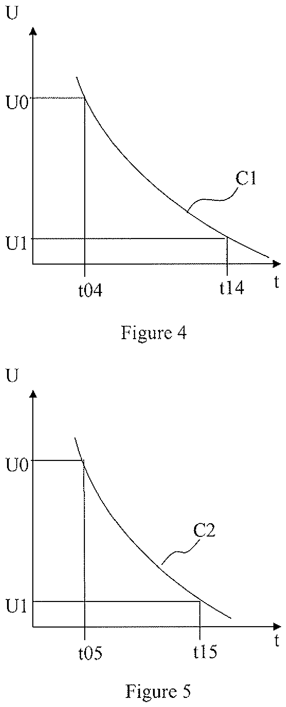

In figure 4, a schematic diagram of a voltage curve C1 indicating a discharge of a battery is shown.

In the illustrated example, the curve C1 is illustrating a nominal curve of the battery, the battery being in a new state, just manufactured, from a specification of the battery, and/or the like. A first voltage U0 is preset to a certain voltage at a first time T04; from the curve one may then read a second voltage U1 at a second T14 indicating the battery as being discharged.

In figure 5, a schematic diagram of a curve C2 indicating a discharge of a battery.

In the illustrated example, the curve C2 is illustrating a voltage curve of the battery, the battery being in a used state, recharged a number of times, used over a period of time and/or the like. A first voltage U0 is preset to a certain voltage at a first time T05 defined as a start voltage (for example, indicating a fully loaded battery). From the curve C2, a second voltage U1 indicating the battery as being discharged at a second T15 may be determined.

An application may then compare a second discharge time T15-T05 of figure 5 with a first discharge time of figure 4, T14-T04, wherein the comparison indicates the performance of the battery at the used state of figure 5. For example, (T15-T05)/(T14-T04) = percentage of original performance. This is a very simplified example and different ways of determining the present performance of the battery may be used. For example, it should be understood that the more used a battery is, the voltage of a battery under a given load may be reduced; this may also be measured to indicate performance of the used battery. Another application may be to determine, for example, a Direct Current resistance of a battery based on a pre-determined pulsed load or loads, a voltage recovery time based on pre-determined load or loads, voltage rise time based on given input or charge current, to run some Global System for Mobile communications GSM load and compare to a pre determined value, and/or the like

In order to determine performance an application may be initiated manually, automatically initiated in a periodic preset manner in the mobile terminal (for example, every month, after every hundredth charging, automatically when fully charged after a recharging cycle and disconnected from the electricity network, and/or the like. The determination of performance may also be performed by initiating a number of known applications of the mobile terminal and to perform measurements based on the execution of the known applications, wherein the energy consumptions of the applications are known.

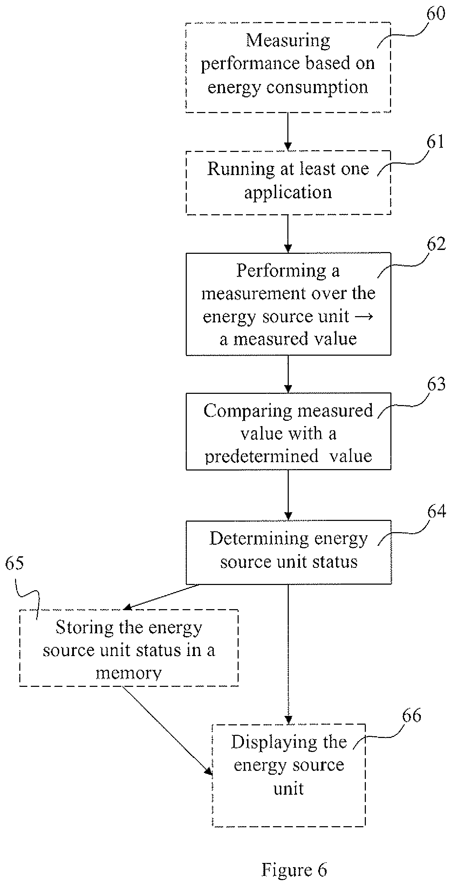

In figure 6, a method in an arrangement of an electronic device is shown. The electronic device may be a mobile terminal such as a mobile phone, a media player, a camera device, and/or the like; any device powered by battery or similar. The method is for determining a performance of an energy source of the electronic device. The performance of the energy source is to be determined for the energy source being in a second state. This performance may then be compared to a performance of the energy source being in a first state. The first state may be when the energy source is new/just manufactured/ just put into the terminal/ a nominal state/ and/or the like. The second state may be when the energy source has been used, for example, a present state, a state after a certain time after manufacturing, a state after a number of charging cycles, and/or the like.

In some embodiments, the electronic device comprises an embedded energy source unit (an embedded battery pack), wherein the energy source unit may not be easily removable, reachable and the service staff may have to disassemble the electronic device to remove the energy source unit to perform a test on the energy source unit. By providing a method performed within the electronic device keeping the electronic device in an operational state without pausing operation or the need to disassemble the electronic device, an efficient and reliable manner to determine performance of the energy source unit of the electronic device is achieved. In some embodiments, the method of determining the performance of the energy source may be performed by an arrangement within a pack comprising the energy source; a so called smart battery pack. In some embodiments, the energy source unit comprises a removable battery.

In optional step 60, the arrangement within the electronic device performs at least one measurement related to the energy consumption of the energy source unit. This measurement may result in a first measured value and may be preformed when the energy source unit is new/just manufactured/ just put into the terminal and/or the like.

In optional step 61, at least one application is executed to determine a performance of the energy source unit at the present time; (the time that the application is executed). In some embodiments, the application is initiated manually from a menu displayed in the electronic device. The application may be initiated automatically when the energy source unit has been fully charged a preset of times. For example, a counter within the electronic device may count the number of times a battery is fully charged (fully charged for example being a preset voltage of measured voltage of the energy source unit).

In some embodiments, the trigger to initiate the determination of performance of the energy source unit may be when a connection to the electricity network is disconnected, for example, when the charger is disconnected from the electronic device/ no feeding current is detected to the energy source.

In step 62, the arrangement within the electronic device performs a measurement over the energy source unit resulting in a measured value. It should here be understood that a plurality of known applications may be executed wherein the energy consumption of the different applications are known and measurements are performed over the executions of these known applications. In some embodiments, the step of performing measurement is performed during the at least one application. In some embodiments, the measured value comprises a measured time, voltage and/or the like.

In step 63, the arrangement within the electronic device compares the measured value with a predetermined value resulting in a difference value. The predetermined value may comprise the first measured value, a value determined from a nominal specification of a type of energy source unit corresponding to a type of the energy source unit of the electronic device and/or the like.

In step 64, the arrangement within the electronic device determines the status of the energy source unit based on the difference value. For example, if the difference value is below a preset threshold value the status of the energy source unit is determined to be functional/fine/operational/good/positive and/or the like. However, if the difference value being equal and below a predetermined threshold value the status if the energy source unit is determined to be dysfunctional/negative/the battery should be replaced/ bad/ and/or the like. It should also be understood that if the difference value is equal a preset threshold value the status may be determined to be functional/fine/operational/good/positive and/or the like.

In optional step 65, the arrangement within the electronic device stores the status of the energy source unit. This may be stored to be retrieved by service staff during repair and/or a user of the electronic device during operation.

In optional step 66, the electronic device displays the status, wherein the displaying of the status may indicate whether to replace the energy source unit or not. In some embodiments, wherein the arrangement is comprised in a smart battery pack, the status may be retrieved/received from the arrangement.

Embodiments are described with reference to block diagrams and/or flowchart illustrations of methods, apparatus (systems). It is understood that several blocks of the block diagrams and/or flowchart illustrations, and combinations of blocks in the block diagrams and/or flowchart illustrations, can be implemented by computer program instructions. These computer program instructions may be provided to a processor of a general purpose computer, special purpose computer, and/or other programmable data processing apparatus to produce a machine, such that the instructions, which execute via the processor of the computer and/or other programmable data processing apparatus, create means for implementing the functions/acts specified in the block diagrams and/or flowchart block or blocks.

These computer program instructions may also be stored in a computer-readable memory that can direct a computer or other programmable data processing apparatus to function in a particular manner, such that the instructions stored in the computer-readable memory produce an article of manufacture including instructions which implement the function/act specified in the block diagrams and/or flowchart block or blocks.

The computer program instructions may also be loaded onto a computer or other programmable data processing apparatus to cause a series of operational steps to be performed on the computer or other programmable apparatus to produce a computer-implemented process such that the instructions which execute on the computer or other programmable apparatus provide steps for implementing the functions/acts specified in the block diagrams and/or flowchart block or blocks..

In some implementations, the functions/acts noted in the blocks may occur out of the order noted in the operational illustrations. For example, two blocks shown in succession may in fact be executed substantially concurrently or the blocks may sometimes be executed in the reverse order, depending upon the functionality/acts involved.

In order to perform the method an arrangement is provided.

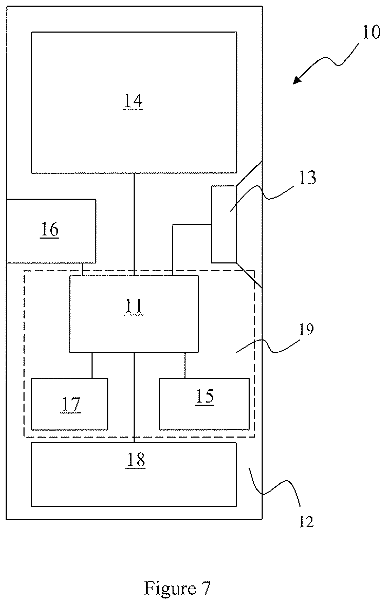

In figure 7, a schematic overview of an arrangement 19 in an electronic device is shown. The electronic device may comprise a mobile terminal such as a mobile phone, a portable media player, a camera, and or the like. In the illustrated example, the electronic device comprises a mobile terminal 10.

The arrangement 19 comprises a control unit 11 arranged to determine a status of an energy source unit 15 indicating performance of the energy source unit 15 connected and assembled within the mobile terminal 10 to feed units and elements of the mobile terminal 10 with power. The control unit 11 is further arranged to perform a measurement over the energy source unit 15 resulting in a measured value, to compare the measured value with a predetermined value resulting in a difference value, and to determine the status of the energy source unit 15 based on the difference value.

The mobile terminal 10 in the illustrated embodiments includes a portable housing assembly 12, a display 14, a user interface (i.e., a man machine interface (MMI)) including a speaker 13 (i.e., a sound transducer), the control unit 11, a communication module 16, and a memory 17. The foregoing components of the mobile terminal 10 may be included in many conventional mobile terminals.

The display 14 may be any suitable display screen assembly. For example, the display screen 14 may be a liquid crystal display (LCD) with or without auxiliary lighting (e.g., a lighting panel), a touch panel and/or the like.

The user interface may include any suitable input device(s) 18 including, for example, a touch activated or touch sensitive device (e.g., a touch screen), a joystick, a keyboard/keypad, a dial, a directional key or keys, and/or a pointing device (such as a mouse, trackball, touch pad, etc.). The speaker 13 generates sound responsive to an input audio signal. The user interface may also include a microphone coupled to an audio processor that is configured to generate an audio data stream responsive to sound incident on the microphone.

In some embodiments, the control unit 11 may further support various functions of the mobile terminal 10. The control unit 11 may be any commercially available or custom microprocessor, for example. In use, the control unit 11 of the mobile terminal 10 generates a display image on the display 14. The control unit 11 may control the components of the mobile terminal 10. However, in some embodiments where the arrangement 19 is comprised in a smart battery pack the arrangement further comprises the energy source unit 15; and the control unit 11 is mainly directed to functions related to the energy source unit 15.

The memory 17 is configured to store digital information signals and data such as measured values and determined values relating to the power consumption and battery performance. In the embodiments of the arrangement being a smart battery pack, the memory 17 may be comprised within the battery pack arranged to store data related to the energy source unit.

The communication module 16 may be configured to communicate data over one or more wireless interfaces to another remote wireless terminal as discussed herein. The communication module 16 can include a cellular communication module, a direct point-to-point connection module, and/or a WLAN module.

With a cellular communication module, the wireless terminal 10 can communicate via the base station(s) of a network using one or more cellular communication protocols such as, for example, Advanced Mobile Phone Service (AMPS), ANSI-136, Global Standard for Mobile (GSM) communication, General Packet Radio Service (GPRS), enhanced data rates for GSM evolution (EDGE), code division multiple access (CDMA), wideband-CDMA, CDMA2000, Universal Mobile Telecommunications System (UMTS), Evolved Packet System (EPS comprising LTE), LTE Advanced and/ or the like

A direct point-to-point connection module may include a direct RF communication module or a direct IR communication module. The direct RF communication module may include a Bluetooth module, a NFC module and/or the like. With a Bluetooth module, the wireless terminal 10 can communicate via an ad-hoc network through a direct point-to-point interface. With a WLAN module, the wireless terminal 10 can communicate through a WLAN, e.g. a router, using a communication protocol that may include, but is not limited to, 802.11a, 802.11b, 802.11e, 802.11g, and/or 802.11i.

The communication module 16 may include a transceiver typically having a transmitter circuit and a receiver circuit, which respectively transmit outgoing radio frequency signals (e.g., to the network, a router or directly to another terminal) and receive incoming radio frequency signals (e.g., from the network, a router or directly to another terminal), such as voice and data signals, via an antenna. The communication module 16 may include a short range transmitter and receiver, such as a Bluetooth/NFC transmitter and receiver and/or the like. The antenna may be an embedded antenna, a retractable antenna or any antenna known to those having skill in the art without departing from the scope of the present invention. The radio frequency signals transmitted between the mobile terminal 10 and the network, router or other terminal may include both traffic and control signals (e.g., paging signals/messages for incoming calls), which are used to establish and maintain communication with another party or destination. The radio frequency signals may also include packet data information, such as, for example, cellular digital packet data (CDPD) information. In addition, the transceiver may include an infrared (IR) transceiver configured to transmit/receive infrared signals to/from other electronic devices via an IR port and/or a NFC Transmitter.

The mobile terminal 10 may also be configured to electrically couple with another terminal via a wireline or cable for the transmission of digital communication signals therebetween. The mobile terminal 10 may include further components such as a camera device configured to generate a still image and/or video data stream based on incident light.

According to some embodiments, the mobile terminal 10 is a handheld mobile terminal. By "handheld mobile terminal," it is meant that the outer dimensions of the mobile terminal are adapted and suitable for use by a typical operator using one hand. According to some embodiments, the total volume of the handheld mobile terminal 10 is less than about 200 cc. According to some embodiments, the total volume of the handheld terminal 10 is less than about 100 cc. According to some embodiments, the total volume of the handheld mobile terminal 10 is between about 50 and 100 cc. According to some embodiments, no dimension of the handheld mobile terminal 10 exceeds about 200 mm.

In some embodiments, it should be understood that the control unit 11 may be arranged to transmit a request for a new energy source unit (battery) over the communication module 16 to a battery supplier in the network when the determination of the performance of the energy source unit 15 indicates that the energy source unit 15 need to be replaced with a new energy source unit 15. Then this may be provided as a service to the user (free, to a cost, or the like).

The control unit 11 may further be arranged to store the status, for example, in a memory of the mobile terminal 10 or the memory within the arrangement 19 and/or to display in the display arrangement 14 the status indicating whether to replace the energy source unit or not.

In some embodiments, the control unit 11 is further arranged to run at least one application wherein the control unit 11 is arranged to perform the measurement during the at least one application. The application may be existent in the mobile terminal/arrangement with a known current consumption, and, in some embodiments, arranged to be initiated manually from a menu displayed in the mobile terminal, automatically when certain criteria are met (for example, a number of recharging cycles has been performed, a certain time period has passed, and/or the like). The application may further be automatically initiated when a charger connected to electricity network is plugged in/out of the mobile terminal detected by a detection circuit detecting feed current and/or the like.

In some embodiments, the predetermined value comprises a value of a measurement received from running the application when the energy source unit is new/just manufactured/ just put into the terminal; determined from a nominal specification of a battery type; and/or the like. The control unit 11 may be arranged to determine type of battery by measuring voltage, resistance, current and/or the like. The control unit 11 may then based on the type of the energy source unit 15 select data of a battery type corresponding to the type of the energy source unit 15.

In some embodiments, the measured value comprises a measured time, voltage, current, and/or the like.

In some embodiments, the energy source unit 15 comprises a removable battery and in some embodiments the energy source unit 15 comprises a battery embedded within the mobile terminal. In some embodiments, a smart battery pack comprises the arrangement including the energy source unit and a memory to store battery data on.

The control unit 11 may comprise a CPU, a single processing unit, a plurality of processing units, and or the like. In some embodiments, where the arrangement is comprised within a smart battery pack the control unit 11 may be comprised by a plurality of control units in communication with each other to perform the determination and displaying the status of the energy source. At least one control unit is arranged in the mobile terminal and at least one control unit is arranged in the arrangement.

The memory unit 17 may comprise a single memory unit, a plurality of memory units, external and/or internal memory units.

In the drawings and specification, there have been disclosed exemplary embodiments of the invention. However, many variations and modifications can be made to these embodiments without substantially departing from the principles of the present invention. Accordingly, although specific terms are employed, they are used in a generic and descriptive sense only and not for purposes of limitation, the scope of the invention being defined by the following claims.

## Claims

1. A method for determining a status of a rechargeable battery (15) indicating performance of the rechargeable battery (15) mounted within the electronic device (10), the method being performed in an electronic device (10) and comprising the steps of:
performing (62) a measurement over the rechargeable battery resulting in a measured value, wherein the measurement is performed during running of at least one application,
comparing (63) the measured value with a predetermined value resulting in a difference value, wherein the predetermined value is a value of a measurement from running the at least one application when the rechargeable battery is new or just manufactured or just put into the terminal or determined from a nominal specification of a battery type corresponding to the battery type of the rechargeable battery of the electronic device, and wherein the at least one application is already included in the electronic device (10) with a known current consumption,
determining (64) the status of the rechargeable battery by comparing the difference value with a preset threshold value, which status indicates whether the rechargeable battery need to be replaced or not; and
displaying (66) either, based on the determined status, that the rechargeable battery need to be replaced or that the rechargeable battery is fine in the electronic device (10).

2. A method according to claim 1, further comprising the step of storing (65) the status of the rechargeable battery.

3. A method according to any of the claims 1-2, wherein the at least one application is initiated manually from a menu displayed in the electronic device.

4. A method according to any of the claims 1-3, wherein the measured value comprises a measured time, current or voltage.

5. An arrangement (19) for an electronic device (10) arranged to determine a status of a rechargeable battery (15) indicating performance of the rechargeable battery (15) mounted within the electronic device (10) comprising a control unit (11) arranged to perform a measurement over the rechargeable battery (15) resulting
in a measured value, to compare the measured value with a predetermined value resulting in a difference value, and to determine the status of the rechargeable battery (15) by comparing the difference value with a preset threshold value, which status indicates whether the rechargeable battery (15) needs to be replaced or not, wherein the control unit (11) is **characterized in** being further arranged to run at least one application wherein the control unit (11) is arranged to perform the measurement during the at least one application, wherein the predetermined value is a value of a measurement from running the at least one application when the rechargeable battery is new or just manufactured or just put into the terminal or determined from a nominal specification of a battery type corresponding to the battery type of the rechargeable battery of the electronic device, and wherein the at least one application is existent in the electronic device (10) with a known current consumption, wherein the control unit (11) is further arranged to display either, based on the determined status, that the rechargeable battery needs to be replaced or that the rechargeable battery is fine in the electronic device (10).

6. An arrangement {19) according to claim 5, wherein the control unit (11) is further arranged to store the status in a memory of the arrangement.

7. An arrangement (19) according to any of the claims 5-6, wherein the at least one application is arranged to be initiated manually from a menu displayed in the electronic device (10).

8. An arrangement (19) according to any of the claims 5-7, wherein the measured value comprises a measured time, voltage or current.

9. An arrangement (19) according to any of the claims 5-8, further comprising the rechargeable battery (15).

10. An electronic device (10) comprising the arrangement (19) according to any of claims 5-9.

11. A battery pack comprising the arrangement (19) according to any of claims 5-9.

## Patentansprüche

1. Verfahren zum Bestimmen eines Status einer wiederaufladbaren Batterie (15), der die Leistung der wiederaufladbaren Batterie (15), die innerhalb der elektronischen Vorrichtung (10) montiert ist, angibt, wobei das Verfahren in einer elektronischen Vorrichtung (10) durchgeführt wird und die folgenden Schritte umfasst:
Durchführen (62) einer Messung über der wiederaufladbaren Batterie, was zu einem gemessenen Wert führt, wobei die Messung während des Ausführens von mindestens einer Anwendung durchgeführt wird,
Vergleichen (63) des gemessenen Werts mit einem vorbestimmten Wert, was zu einem Differenzwert führt, wobei der vorbestimmte Wert ein Wert einer Messung von dem Ausführen der mindestens einen Anwendung ist, wenn die wiederaufladbare Batterie neu oder gerade hergestellt oder gerade in das Endgerät eingesetzt ist oder von einer nominellen Angabe eines Batterietyps, der dem Batterietyp der wiederaufladbaren Batterie der elektronischen Vorrichtung entspricht, bestimmt wird, und wobei die mindestens eine Anwendung bereits in der elektronischen Vorrichtung (10) mit einem bekannten Stromverbrauch enthalten ist,
Bestimmen (64) des Status der wiederaufladbaren Batterie, indem der Differenzwert mit einem voreingestellten Schwellenwert verglichen wird, wobei der Status angibt, ob die wiederaufladbare Batterie ersetzt werden muss oder nicht; und
Anzeigen (66) entweder, basierend auf dem bestimmten Status, dass die wiederaufladbare Batterie ersetzt werden muss oder dass die wiederaufladbare Batterie in der elektronischen Vorrichtung (10) in Ordnung ist.

2. Verfahren nach Anspruch 1, ferner umfassend den Schritt des Speicherns (65) des Status der wiederaufladbaren Batterie.

3. Verfahren nach eine der Ansprüche 1-2, wobei die mindestens eine Anwendung manuell von einem Menü gestartet wird, das in der elektronischen Vorrichtung angezeigt wird.

4. Verfahren nach einem der Ansprüche 1-3, wobei der gemessene Wert eine gemessene Zeit, Strom oder Spannung umfasst.

5. Anordnung (19) für eine elektronische Vorrichtung (10), die angeordnet ist, um einen Status einer wiederaufladbaren Batterie (15) zu bestimmen, der die Leistung der wiederaufladbaren Batterie (15) angibt, die innerhalb der elektronischen Vorrichtung (10) angeordnet ist, umfassend eine Steuereinheit (11), die angeordnet ist, um eine Messung über der wiederaufladbaren Batterie (15) durchzuführen, was zu einem gemessenen Wert führt, um den gemessenen Wert mit einem vorbestimmten Wert zu vergleichen, was zu einem Differenzwert führt, und um den Status der wiederaufladbaren Batterie (15) zu bestimmen, indem der Differenzwert mit einem voreingestellten Schwellenwert verglichen wird, wobei der Status angibt, ob die wiederaufladbare Batterie (15) ersetzt werden muss oder nicht, wobei die Steuereinheit (11) **dadurch gekennzeichnet ist, dass** sie ferner angeordnet ist, um mindestens eine Anwendung auszuführen, wobei die Steuereinheit (11) angeordnet ist, um die Messung während der mindestens einen Anwendung durchzuführen, wobei der vorbestimmte Wert ein Wert einer Messung von dem Ausführen der mindestens einen Anwendung ist, wenn die wiederaufladbare Batterie neu oder gerade hergestellt oder gerade in das Endgerät eingesetzt ist oder von einer nominellen Angabe eines Batterietyps, der dem Batterietyp der wiederaufladbaren Batterie der elektronischen Vorrichtung entspricht, bestimmt wird, und wobei die mindestens eine Anwendung bereits in der elektronischen Vorrichtung (10) mit einem bekannten Stromverbrauch existiert, wobei die Steuereinheit (11) ferner angeordnet ist, um entweder, basierend auf dem bestimmten Status, anzuzeigen, dass die wiederaufladbare Batterie ersetzt werden muss oder dass die wiederaufladbare Batterie in der elektronischen Vorrichtung (10) in Ordnung ist.

6. Anordnung (19) nach Anspruch 5, wobei die Steuereinheit (11) ferner angeordnet ist, um den Status in einem Speicher der Anordnung zu speichern.

7. Anordnung (19) nach einem der Ansprüche 5-6, wobei die mindestens eine Anwendung manuell von einem Menü gestartet wird, das in der elektronischen Vorrichtung (10) angezeigt wird.

8. Anordnung (19) nach einem der Ansprüche 5-7, wobei der gemessene Wert eine gemessene Zeit, Strom oder Spannung umfasst.

9. Anordnung (19) nach einem der Ansprüche 5-8, ferner umfassend die wiederaufladbare Batterie (15).

10. Elektronische Vorrichtung (10), umfassend die Anordnung (19) nach einem der Ansprüche 5-9.

11. Batteriepack, umfassend die Anordnung (19) nach einem der Ansprüche 5-9.

## Revendications

1. Procédé pour déterminer un état d'une batterie rechargeable (15) indiquant une performance de la batterie rechargeable (15) montée à l'intérieur d'un dispositif électronique (10), le procédé étant réalisé dans un dispositif électronique (10) et comprenant les étapes consistant à :
réaliser (62) une mesure sur la batterie rechargeable résultant en une valeur mesurée, dans lequel la mesure est réalisée durant une exécution d'au moins une application,
comparer (63) la valeur mesurée à une valeur prédéterminée résultant en une valeur de différence, dans lequel la valeur prédéterminée est une valeur d'une mesure à partir de l'exécution de l'au moins une application lorsque la batterie rechargeable est nouvelle ou justement fabriquée ou justement mise dans le terminal ou déterminée à partir d'une spécification nominale d'un type de batterie correspondant au type de batterie de la batterie rechargeable du dispositif électronique, et dans lequel l'au moins une application est déjà incluse dans le dispositif électronique (10) avec une consommation de courant connue,
déterminer (64) l'état de la batterie rechargeable par comparaison de la valeur de différence à une valeur de seuil prédéfinie, lequel état indique si la batterie rechargeable nécessite d'être remplacée ou non ; et
afficher (66), sur la base de l'état déterminé, soit que la batterie rechargeable nécessite d'être remplacée, soit que la batterie rechargeable est en parfait état dans le dispositif électronique (10).

2. Procédé selon la revendication 1, comprenant en outre l'étape de stockage (65) de l'état de la batterie rechargeable.

3. Procédé selon l'une quelconque des revendications 1 à 2, dans lequel l'au moins une application est lancée manuellement à partir d'un menu affiché dans le dispositif électronique.

4. Procédé selon l'une quelconque des revendications 1 à 3, dans lequel la valeur mesurée comprend un temps, un courant ou une tension mesurés.

5. Agencement (19) pour un dispositif électronique (10) agencé pour déterminer un état d'une batterie rechargeable (15) indiquant une performance de la batterie rechargeable (15) montée à l'intérieur du dispositif électronique (10) comprenant une unité de commande (11) agencée pour réaliser une mesure sur la batterie rechargeable (15) résultant en une valeur mesurée, pour comparer la valeur mesurée à une valeur prédéterminée résultant en une valeur de différence, et pour déterminer l'état de la batterie rechargeable (15) par comparaison de la valeur de différence à une valeur de seuil prédéfinie, lequel état indique si la batterie rechargeable (15) nécessite d'être remplacée ou non, dans lequel l'unité de commande (11) est **caractérisée en ce qu'**elle est en outre agencée pour exécuter au moins une application dans lequel l'unité de commande (11) est agencée pour réaliser la mesure durant l'au moins une application, dans lequel la valeur prédéterminée est une valeur d'une mesure à partir de l'exécution de l'au moins une application lorsque la batterie rechargeable est nouvelle ou justement fabriquée ou justement mise dans le terminal ou déterminée à partir d'une spécification nominale d'un type de batterie correspondant au type de batterie de la batterie rechargeable du dispositif électronique, et dans lequel l'au moins une application est présente dans le dispositif électronique (10) avec une consommation électrique connue, dans lequel l'unité de commande (11) est en outre agencée pour afficher, sur la base de l'état déterminé, soit que la batterie rechargeable nécessite d'être remplacée, soit que la batterie rechargeable est en parfait état dans le dispositif électronique (10).

6. Agencement (19) selon la revendication 5, dans lequel l'unité de commande (11) est en outre agencée pour stocker l'état dans une mémoire de l'agencement.

7. Agencement (19) selon l'une quelconque des revendications 5 à 6, dans lequel l'au moins une application est agencée pour être lancée manuellement à partir d'un menu affiché dans le dispositif électronique (10).

8. Agencement (19) selon l'une quelconque des revendications 5 à 7, dans lequel la valeur mesurée comprend un temps, une tension ou un courant mesurés.

9. Agencement (19) selon l'une quelconque des revendications 5 à 8, comprenant en outre la batterie rechargeable (15).

10. Dispositif électronique (10) comprenant l'agencement (19) selon l'une quelconque des revendications 5 à 9.

11. Bloc-batterie comprenant l'agencement (19) selon l'une quelconque des revendications 5 à 9.
